Europäisches Patentamt

European Patent Office

Office européen des brevets

(19)

(11) Veröffentlichungsnummer: **0 237 851**
**A2**

(12) # EUROPÄISCHE PATENTANMELDUNG

(21) Anmeldenummer: **87102842.9**

(22) Anmeldetag: **27.02.87**

(51) Int. Cl.³: **H 01 L 21/92**

(30) Priorität: **21.03.86 DE 3610036**

(43) Veröffentlichungstag der Anmeldung:
**23.09.87  Patentblatt  87/39**

(84) Benannte Vertragsstaaten:
**BE CH DE ES FR GB IT LI LU NL SE**

(71) Anmelder: **SCHERING AKTIENGESELLSCHAFT Berlin
und Bergkamen
Müllerstrasse 170/178 Postfach 65 03 11
D-1000 Berlin 65(DE)**

(72) Erfinder: **Bock, Martin, Dr.
Senheimer Strasse 19
D-1000 Berlin 28(DE)**

(72) Erfinder: **Tenbrink, Detlef
Büdnerring 42
D-1000 Berlin 51(DE)**

(54) **Kontaktieren von mikroelektronischen Schaltungen.**

(57) Die Erfindung betrifft die Verwendung von galvanisch abgeschiedenen Aluminiumschichten zum Kontaktieren von mikroelektronischen Schaltungen.

EP 0 237 851 A2

Die Erfindung betrifft die Verwendung von galvanisch abgeschiedenen Aluminiumschichten zum Kontaktieren von mikroelektronischen Schaltungen.

Es ist bekannt, aus nichtwässrigen Lösungen unter Schutzgas Alumiumschichten galvanisch abzuscheiden , (EP - PS O 042 504) derartige Schichten finden Verwendung für den Korrisionsschutz.

In der Mikroelektronik werden Halbleiterbausteine im allgemeinen durch Ultraschallschweißen mit der Trägerschaltung elektrisch verbunden. Man unterscheidet das Drahtbonden, bei dem ein geeignetes Werkzeug (Keil oder Kapillare) den Draht mit Hilfe von Ultraschall oder Ultraschall und Wärme auf die Kontaktflecken der Halbleiter- und die Trägerschaltung schweißt, und Simultankontaktierungsverfahren, bei denen die Kontaktfahnen eines Zwischenträgers mit Hilfe eines geeigneten Werkzeugs auf die Halbleiter- und in einem weiteren Schritt auf die Trägerschaltung geschweißt werden.

Aus metallurgischen und verfahrenstechnischen Gründen haben sich auf der Seite der Halbleiter aufgedampfte Aluminiumschichten durchgesetzt. Auf den Trägerschaltungen findet man vorwiegend Goldmetallisierungen, die aufgedampft, galvanisch abgeschieden oder als Paste gedruckt wurden. Nahezu alle Schaltungen werden heute mit Aluminium- oder Golddrähten kontaktiert. Dies führt stets zu der Materialpaarung Aluminium-Gold, entweder auf dem Halbleiter beim Bonden mit Golddraht oder auf der Trägerschaltung beim Bonden mit Aluminiumdraht. Diese Materialpaarung kann durch Bildung intermetallischer Phasen, der sogenannten Purpurpest, oder durch Kontakt-

Postanschrift: Schering Aktiengesellschaft, Postfach 65 03 11, D-1000 Berlin 65 · Für Besucher: Berlin-Wedding, Müllerstraße 170-178 · Telegramme: Scheringchemie Berlin.

Vorstand: Dr. Herbert Asmis, Dr. Christian Bruhn, Dr. Heinz Hennes, Horst Kramp, Dr. Klaus Pohle, Dr. Horst Witzel · Vorsitzender des Aufsichtsrats: Hans-Jürgen Hamann
Sitz der Gesellschaft: Berlin und Bergkamen · Handelsregister: AG Charlottenburg 93 HRB 283 und AG Kamen HRB 0061 · Berliner Commerzbank AG, Berlin, Konto-Nr.
108700600, Bankleitzahl 100 400 00 · Berliner Handels- und Frankfurter Bank, Berlin, Konto-Nr. 70045224, Bankleitzahl 100 202 00 · Deutsche Bank Berlin AG, Konto-Nr.
2415008, Bankleitzahl 100 700 00 · Postscheckamt Berlin West, Konto-Nr. 11 75-101, Bankleitzahl 100 100 10

korrosion zu einer verminderten Zuverlässigkeit der gesamten Schaltung führen.

Aufgabe der vorliegenden Erfindung ist die Verwendung
einer mit üblichen Drahtmaterialien und Schweißverfahren
verträglichen Metallisierung zum Kontaktieren von mikroelektronischen Schaltungen.

Diese Aufgabe wird erfindungsgemäß durch die Verwendung
von galvanisch abgeschiedenen Aluminiumschichten gelöst.

Diese erfindungsgemäß verwendeten Metallisierungen dienen
als Kontaktflecken für Ultraschweißverfahren und sind überraschenderweise in hervorragender Weise für alle üblichen
Drahtmaterialien und Schweißverfahren verträglich.

Besondere Vorteile bestehen weiterhin darin,
daß im Gegensatz zu den üblichen Goldmetallisierungen bei der
Ätzung keine Unterätzung infolge Kontaktkorrision auftritt,
so daß auch dicke Aluminiumschichten als bondbare Schichten
möglich sind,

daß beim Bonden mit Aluminiumdraht keine Purpurpest oder
Kontaktkorrosion auftreten kann und

daß die Beschichtung kostengünstig im Vergleich zu Gold
ist.

Diese erfindungsgemäße Verwendung der galvanisch abgeschiedenen Aluminiumschichten hat außerdem den Vorteil einer kostengünstigen Metallisierung bei Simultankontaktierungsverfahren.

-3-

Postanschrift: Schering Aktiengesellschaft, Postfach 65 03 11, D-1000 Berlin 65 · Für Besucher: Berlin-Wedding, Müllerstraße 170-178 · Telegramme: Scheringchemie Berlin.

Vorstand: Dr. Herbert Asmis, Dr. Christian Bruhn, Dr. Heinz Hannse, Horst Kramp, Dr. Klaus Pohle, Dr. Horst Witzel · Vorsitzender des Aufsichtsrats: Hans-Jürgen Hemann
Sitz der Gesellschaft: Berlin und Bergkamen · Handelsregister: AG Charlottenburg 93 HRB 283 und AG Kamen HRB 0061 · Berliner Commerzbank AG, Berlin, Konto-Nr.
108700600, Bankleitzahl 100 400 00 · Berliner Handels- und Frankfurter Bank, Berlin, Konto-Nr. 70045224, Bankleitzahl 100 202 00 · Deutsche Bank Berlin AG, Konto-Nr.
2415008, Bankleitzahl 100 700 00 · Postscheckamt Berlin West, Konto-Nr. 11 75-101, Bankleitzahl 100 100 10

Weiterhin bieten diese Galvanoaluminiumschichten einen hervorragenden Anlaufschutz für Leiterbahnen aus Kupfer und sind daher auch für preisgünstige Hochfrequenzschaltungen gut geeignet. Das galvanische Aluminium wird von den üblichen Loten nicht benetzt, wodurch eine gesonderte Lötstopschicht für den Einsatz des Reflow- oder Wellenlötverfahrens eingespart wird. Die Verbindungen mit Aluminiumdraht weisen eine sehr hohe Zuverlässigkeit auf. Auch Verbindungen mit Golddraht sind ohne Probleme herzustellen.

Die folgenden Beispiele dienen zur Erläuterung der Erfindung.

Postanschrift: Schering Aktiengesellschaft, Postfach 65 03 11, D-1000 Berlin 65 · Für Besucher: Berlin-Wedding, Müllerstraße 170-178 · Telegramme: Scheringchemie Berlin
Vorstand: Dr. Herbert Asmis, Dr. Christian Bruhn, Dr. Heinz Hennse, Horst Kramp, Dr. Klaus Pohle, Dr. Horst Witzel · Vorsitzender des Aufsichtsrats: Hans-Jürgen Hamann
Sitz der Gesellschaft: Berlin und Bergkamen · Handelsregister: AG Charlottenburg 93 HRB 283 und AG Kamen HRB 0061 · Berliner Commerzbank AG, Berlin, Konto-Nr.
108700600, Bankleitzahl 100 400 00 Berliner Handels- und Frankfurter Bank, Berlin, Konto-Nr. 70045224, Bankleitzahl 100 202 00 · Deutsche Bank Berlin AG, Konto-Nr.
2415008, Bankleitzahl 100 700 00 Postscheckamt Berlin West, Konto-Nr. 11 75-101, Bankleitzahl 100 100 10

**B e i s p i e l 1**

Ein Schaltungsträger aus Aluminiumoxid wurde nach einer geeigneten Vorbehandlung und der Aktivierung in einem Palladiumionen enthaltenden Aktivator chemisch verkupfert und anschließend galvanisch aluminiert. Nach Aufbringen eines geeigneten Resists wurde mit verdünnter Salzsäure das Aluminium über den Lötflecken entfernt, der Resist abgelöst und nach erneutem Auftragen eines Resists wurden nach Belichtung und Entwicklung die Leiterstrukturen und Bondflecken in einem weiteren Ätzschritt strukturiert. Die Kontaktierung des Halbleiters erfolgte durch Ultraschallschweißen mit Aluminiumdraht von 25 um Durchmesser.

-7-

Postanschrift: Schering Aktiengesellschaft, Postfach 66 03 11, D-1000 Berlin 65 · Für Besucher: Berlin-Wedding, Müllerstraße 170-178 · Telegramme: Scheringchemie Berlin
Vorstand: Dr. Herbert Asmis, Dr. Christian Bruhn, Dr. Heinz Hannes, Horst Kramp, Dr. Klaus Pohle, Dr. Horst Witzel · Vorsitzender des Aufsichtsrats: Hans-Jürgen Hamann
Sitz der Gesellschaft: Berlin und Bergkamen · Handelsregister: AG Charlottenburg 93 HRB 283 und AG Kamen HRB 0061 · Berliner Commerzbank AG, Berlin, Konto-Nr.
108700600, Bankleitzahl 100 400 00 · Berliner Handels- und Frankfurter Bank, Berlin, Konto-Nr. 70045224, Bankleitzahl 100 202 00 · Deutsche Bank Berlin AG, Konto-Nr.
2415008, Bankleitzahl 100 700 00 · Postscheckamt Berlin West, Konto-Nr. 11 75-101, Bankleitzahl 100 100 10

B e i s p i e l   2

Ein mit Tantal und Nickel durch Kathodenzerstäuben metallisiertes Keramikplättchen wurde mit 50 um Aluminium galvanisiert und mit einem alkalibeständigen Resist beschichtet, der so belichtet und entwickelt wurde, daß beim anschließenden Sprühätzen mit verdünnter Natronlauge Höcker aus Aluminium entstanden, deren Anordnung dem Spiegelbild der Bondflecken einer Halbleiterschaltung entsprach. Nach Entfernung des Resists wurden mit Hilfe weiterer Photolack- und Ätzschritte die Leiter- und Widerstandsstrukturen erzeugt und die Halbleiterschaltung mit Hilfe eines speziellen Werkzeugs durch Ultraschall direkt aufgeschweißt.

Postanschrift: Schering Aktiengesellschaft, Postfach 65 03 11, D-1000 Berlin 66 · Für Besucher: Berlin-Wedding, Müllerstraße 170-178 · Telegramme: Scheringchemie Berlin

Vorstand: Dr. Herbert Asmis, Dr. Christian Bruhn, Dr. Heinz Hannse, Horst Kramp, Dr. Klaus Pohle, Dr. Horst Witzel · Vorsitzender des Aufsichtsrats: Hans-Jürgen Hamann
Sitz der Gesellschaft: Berlin und Bergkamen · Handelsregister: AG Charlottenburg 93 HRB 283 und AG Kamen HRB 0061 · Berliner Commerzbank AG, Berlin, Konto-Nr
108700600, Bankleitzahl 100 400 00 · Berliner Handels- und Frankfurter Bank, Berlin, Konto-Nr 70045224, Bankleitzahl 100 202 00 · Deutsche Bank Berlin AG, Konto-Nr
2415008, Bankleitzahl 100 700 00 · Postscheckamt Berlin West, Konto-Nr. 11 75-101, Bankleitzahl 100 100 10

B e i s p i e l   3

Auf einer Siliziumscheibe mit fertig strukturierten Schaltungen wurden nach Passivierung die Bondflecken galvanisch mit Aluminium auf 5Ø um verstärkt. Die Metallisierung eines flexiblen Zwischenträgers wurde mit 3 umgalvanisch abgeschiedenem Aluminium versehen, das anschließend teilweise im äußeren Bereich wieder abgeätzt wurde. Nach Ätzung der Leiterstruktur des Zwischenträgers wurde in inneren Bereich die aus der Siliziumscheibe gesägte integrierte Schaltung mit einem geeigneten Werkzeug unter Anwendung von Ultraschallenergie aufgeschweißt und anschließend schließend der Zwischenträger auf eine Leiterplatte gelötet.

Postanschrift: Schering Aktiengesellschaft, Postfach 65 03 11, D-1000 Berlin 65 · Für Besucher: Berlin-Wedding, Müllerstraße 170-178   Telegramme: Scheringchemie Berlin.

Vorstand. Dr. Herbert Asmis, Dr. Christian Bruhn, Dr. Heinz Hannse, Horst Kramp, Dr. Klaus Pohle, Dr. Horst Witzel · Vorsitzender des Aufsichtsrats: Hans-Jürgen Hamann
Sitz der Gesellschaft: Berlin und Bergkamen · Handelsregister: AG Charlottenburg 93 HRB 283 und AG Kamen HRB 0081 · Berliner Commerzbank AG, Berlin, Konto-Nr.
108700600, Bankleitzahl 100 400 00 · Berliner Handels- und Frankfurter Bank, Berlin, Konto-Nr. 70045224, Bankleitzahl 100 202 00 · Deutsche Bank Berlin AG, Konto-Nr.
2415006, Bankleitzahl 100 700 00 · Postscheckamt Berlin West, Konto-Nr. 11 75-101, Bankleitzahl 100 100 10

## Beispiel 4

Wie in Beispiel 3 wurde ein flexibler Zwischenträger galvanisch aluminiert und dessen Leiterstruktur geätzt. Anschließend wurden im inneren Bereich die Kontaktflecken des Halbleiters auf die aluminierten Leiterbahnen des Zwischenträgers geschweißt und die äußeren Leiterbahnenden in einem weiteren Arbeitsgang simultan auf einen Schaltungsträger, der wie in Beispiel 1 hergestellt war, geschweißt.

-10-

Postanschrift: Schering Aktiengesellschaft, Postfach 65 03 11, D-1000 Berlin 65 · Für Besucher Berlin-Wedding, Müllerstraße 170-178 Telegramme Scheringchemie Be

Vorstand Dr Herbert Asmis, Dr Christian Bruhn Dr Heinz Hannse, Horst Kramp, Dr Klaus Pohle, Dr Horst Witzel · Vorsitzender des Aufsichtsrats· Hans-Jürgen Ham. Sitz der Gesellschaft Berlin und Bergkamen Handelsregister AG Charlottenburg 93 HRB 283 und AG Kamen HRB 0061 · Berliner Commerzbank AG. Berlin. Konto 108700600. Bankleitzahl 100 400 00 Berliner Handels- und Frankfurter Bank Berlin. Konto-Nr 70045224. Bankleitzahl 100 202 00 Deutsche Bank Berlin AG. Konto 2415008. Bankleitzahl 100 700 00 Postscheckamt Berlin West. Konto-Nr 11 75-101. Bankleitzahl 100 100 10

**B e i s p i e l   5**

Ein keramisches Substrat wird wie in Beispiel 1 mit
5 $\mu$m chemisch Kupfer ganzflächig metallisiert. Danach
wird ein Polyimid-Fotolack aufgeschleudert und nach
dem Trocknen durch eine Fotomaske belichtet. Nach der
Entwicklung sind die Bondflächen und die Leiterbahnen
freigelegt, nicht aber die Lötanschlußflächen. Mit dem
vorgeschriebenen Temperaturprofil wird der Lack unter
Schutzgas vollständig in Polyimid umgewandelt. Anschließend
erfogt die semiadditive Abscheidung von 5 $\mu$m Aluminium
auf dem freigelegten Kupfer. Danach wird das Polyimid, das
als Galvanoresist diente, wieder alkalisch entfernt.

Eine weitere Fotoresistbeschichtung deckt alle Leiterbahnen, Bondpads und auch die Lötpads ab, so daß nach dem
Entwickeln die überflüssige Kupferschicht weggeätzt werden
kann.

Postanschrift: Schering Aktiengesellschaft, Postfach 65 03 11, D-1000 Berlin 65 · Für Besucher: Berlin-Wedding, Müllerstraße 170-178 · Telegramme: Scheringchemie Be

Vorstand: Dr Herbert Asmis, Dr Christian Bruhn, Dr Heinz Hannse, Horst Kramp, Dr Klaus Pohle, Dr Horst Witzel · Vorsitzender des Aufsichtsrats: Hans-Jürgen Hem
Sitz der Gesellschaft: Berlin und Bergkamen · Handelsregister: AG Charlottenburg 93 HRB 263 und AG Kamen HRB 0061 · Berliner Commerzbank AG, Berlin, Konto-
108700500 Bankleitzahl 100 400 00   Berliner Handels- und Frankfurter Bank, Berlin, Konto-Nr. 70045224, Bankleitzahl 100 202 00 · Deutsche Bank Berlin AG, Konto-
24:5008 Bankleitzahl 100 700 00 · Postscheckamt Berlin West, Konto-Nr. 11 75-101, Bankleitzahl 100 100 10

## Beispiel 6

Ohne die Notwendigkeit von Polyimid als Galvanoresist und ohne gesonderte Strukturierung des Galvanoaluminiums kommt folgendes Verfahren aus:

Ein keramisches Substrat wird wie im Beispiel 1 ganzflächig mit Kupfer metallisiert und in bekannter Weise durch einen Fotolackprozess subtraktiv strukturiert. Isolierte Leiterzüge sind jedoch durch Kurzschlußverbindungen leitfähig miteinander verbunden, so daß bei der galvanischen Aluminierung alle Kupferstrukturen auch an den seitlichen Flanken beschichtet werden. Zuletzt werden die Kurzschlußverbindungen mit einem Laser wieder aufgetrennt.

Postanschrift: Schering Aktiengesellschaft, Postfach 65 03 11, D-1000 Berlin 65 · Für Besucher· Berlin-Wedding, Müllerstraße 170-178 · Telegramme· Scheringche

Vorstand: Dr. Herbert Asmis, Dr. Christian Bruhn, Dr Heinz Hannse, Horst Kramp, Dr Klaus Pohle, Dr Horst Witzel · Vorsitzender des Aufsichtsrats: Hans-Jürge
Sitz der Gesellschaft. Berlin und Bergkamen   Handelsregister· AG Charlottenburg 93 HRB 283 und AG Kamen HRB 0061 · Berliner Commerzbank AG, Berlin,
106700600, Bankleitzahl 100 400 00   Berliner Handels- und Frankfurter Bank, Berlin, Konto-Nr 70045224, Bankleitzahl 100 202 00 · Deutsche Bank Berlin AG,
2415006, Bankleitzahl 100 700 00 · Postscheckamt Berlin West, Konto-Nr 11 75-101, Bankleitzahl 100 100 10

## P A T E N T A N S P R Ü C H E

1. Verwendung von galvanisch abgeschiedenen Aluminiumschichten zum Kontaktieren von mikroelektronischen Schaltungen.

2. Verwendung von galvanisch abgeschiedenen Aluminiumschichten gemäß Anspruch 1, dadurch gekennzeichnet, daß diese eine leitfähige Metallschicht bedecken und nach Abdecken mit geeigneten Resisten geätzt werden.

3. Verwendung von galvanisch abgeschiedenen Aluminiumschichten gemäß Anspruch 1, dadurch gekennzeichnet, daß deren Herstellung durch Erzeugung einer leitfähigen Metallschicht auf einem Schaltungsträger durch chemische Metallisierung, Aufdampfen oder Kathodenzerstäuben erfolgt, auf der eine Aluminiumschicht galvanisch abgeschieden und anschließend nach Abdecken mit geeigneten Resisten geätzt wird.

4. Verwendung von galvanisch abgeschiedenen Aluminiumschichten gemäß Anspruch 1, dadurch gekennzeichnet, daß ein Siliziumträger nach der Herstellung der Schaltungsstrukturen außerhalb der Kontaktflecken passiviert und letztere galvanisch mit Aluminium verstärkt werden.

5. Verwendung von galvanisch abgeschiedenen Aluminiumschichten gemäß Anspruch 1, dadurch gekennzeichnet, daß ein Zwischenträger mit einer galvanischen Aluminierung versehen und dann geätzt wird.

-2-

Postanschrift: Schering Aktiengesellschaft, Postfach 65 03 11, D-1000 Berlin 65 · Für Besucher: Berlin-Wedding, Müllerstraße 170-178   Telegramme: Scheringchemie Berlin

Vorstand: Dr Herbert Asmis, Dr Christian Bruhn, Dr Heinz Hannse, Horst Kramp, Dr. Klaus Pohle, Dr Horst Witzel · Vorsitzender des Aufsichtsrats: Hans-Jürgen Hamann
Sitz der Gesellschaft: Berlin und Bergkamen   Handelsregister: AG Charlottenburg 93 HRB 283 und AG Kamen HRB 0061   Berliner Commerzbank AG, Berlin, Konto-Nr.
108700600  Bankleitzahl 100 400 00   Berliner Handels- und Frankfurter Bank, Berlin, Konto-Nr 70045224, Bankleitzahl 100 202 00   Deutsche Bank Berlin AG, Konto-Nr
2415008, Bankleitzahl 100 700 00   Postscheckamt Berlin West Konto-Nr 11 75-101, Bankleitzahl 100 100 10

6. Verwendung von galvanisch abgeschiedenen Aluminiumschichten gemäß Anspruch 1, dadurch gekennzeichnet, daß nach chemischer Metallisierung des Substrates eine fotostrukturierte Polyimidschicht aufgebracht wird, die eine galvanische Abscheidung des Aluminiums nur an den Bondpads zuläßt und/oder nur dort, wo eine Lötstopschicht auf den Leiterbahnen gewünscht wird.

7. Halbleiter hergestellt unter Verwendung von galvanisch abgeschiedenen Aluminiumschichten gemäß Ansprüchen 1 bis 6.

Postanschrift: Schering Aktiengesellschaft, Postfach 65 03 11, D-1000 Berlin 65 · Für Besucher: Berlin-Wedding, Müllerstraße 170-178 · Telegramme: Scheringchemie Berlin.

Vorstand: Dr. Herbert Asmis, Dr. Christian Bruhn, Dr. Heinz Hannsa, Horst Kramp, Dr. Klaus Pohle, Dr. Horst Witzel · Vorsitzender des Aufsichtsrats: Hans-Jürgen Hamann
Sitz der Gesellschaft: Berlin und Bergkamen · Handelsregister: AG Charlottenburg 93 HRB 283 und AG Kamen HRB 0061 · Berliner Commerzbank AG, Berlin, Konto-Nr.
106700600, Bankleitzahl 100 400 00   Berliner Handels- und Frankfurter Bank, Berlin, Konto-Nr. 70045224, Bankleitzahl 100 202 00 · Deutsche Bank Berlin AG, Konto-Nr.
2415006, Bankleitzahl 100 700 00   Postscheckamt Berlin West, Konto-Nr. 11 75-101, Bankleitzahl 100 100 10